# EUROPEAN PATENT APPLICATION

(11) **EP 3 358 634 A1**
(43) Date of publication of application: **08.08.2018**
(21) Application number: 16850692.1
(22) Date of filing: 03.10.2016
(51) Int. Cl.: H01L 35/30, H01L 35/32, H02N 11/00

(54) **THERMOELECTRIC POWER GENERATION DEVICE AND THERMOELECTRIC POWER GENERATION METHOD**

(30) Priority: 01.10.2015 JP 2015195986
(71) Applicant: Panasonic Intellectual Property Management Co., Ltd., Osaka-shi, Osaka 540-6207 (JP); Hisaka Works, Ltd., Osaka-shi, Osaka 530-0057 (JP); Chiyoda Corporation, Kanagawa 220-8765 (JP)
(72) Inventor: YUKAWA, Noriaki, Kadoma-shi Osaka 571-8501 (JP); KANOU, Hisashi, Kadoma-shi Osaka 571-8501 (JP); MITSUYASU, Toshio, Kadoma-shi Osaka 571-8501 (JP); MIYAMOTO, Yutaka, Kadoma-shi Osaka 571-8501 (JP); NAKAMURA, Shinji, Kadoma-shi Osaka 571-8501 (JP); IIJIMA, Koji, Kadoma-shi Osaka 571-8501 (JP); MATSUSHITA, Minoru, Higashi-osaka-shi Osaka 578-0973 (JP); YANAGIHARA, Masamune, Higashi-osaka-shi Osaka 578-0973 (JP); MATSUDA, Kazuo, Yokohama-shi Kanagawa 220-8765 (JP); MATSUMOTO, Tadashi, Yokohama-shi Kanagawa 220-8765 (JP); HIRAI, Toshihide, Yokohama-shi Kanagawa 220-8765 (JP); TANAKA, Satoshi, Yokohama-shi Kanagawa 220-8765 (JP)
(74) Representative: Dehns
(86) International application number: PCT/JP2016/004456
(87) International publication number: WO 2017/056514

(57) **Abstract**

A thermoelectric power generation device (1) comprises a plurality of units (7) that are stacked upon one another, each unit including a thermoelectric module (5) containing at least one thermoelectric element (15A, 15B), and a first plate (2) and a second plate (3) interposing the thermoelectric module therebetween, wherein a spacer (32) is interposed between a surface (2A) of one of the first plates facing away from the corresponding thermoelectric module and a surface (3B) of the opposing second plate facing away from the corresponding thermoelectric module, the spacer contacting the first plate and the second plate and defining a fluid passage (51, 52) jointly with the first plate and the second plate, and wherein the fluid passages defined between the adjacent units are configured to receive supply of high temperature fluid and low temperature fluid in an alternating manner in a stacking direction of the units. The plates can be conformed to the thermoelectric module, and the stiffness of the plate can be increased.

## Description

### TECHNICAL FIELD

The present invention relates to a device and a method for thermoelectric power generation using a thermoelectric element utilizing a temperature difference between a high temperature fluid and a low temperature fluid supplied thereto.

### BACKGROUND ART

Power generation systems using a thermoelectric element that converts thermal energy into electric energy by Seebeck effect are known (Patent Document 1, for example). In the prior art disclosed in Patent Document 1, a thermoelectric element is interposed between a pair of thermally conductive plates to form a plate-like thermoelectric power generation unit, and a plurality of plate-like thermoelectric power generation units are stacked so as to define high temperature fluid passages for conducting high temperature fluid and low temperature fluid passages for conducting low temperature fluid.

### PRIOR ART DOCUMENT(S)

### PATENT DOCUMENT(S)

Patent Document 1: JP2009-81970A

### SUMMARY OF THE INVENTION

### TASK TO BE ACCOMPLISHED BY THE INVENTION

The plates interposing a thermoelectric module comprising a plurality of thermoelectric elements are preferably provided with a large contact area with the thermoelectric module in order to promote heat exchange with the thermoelectric module. For this reason, it is preferable that the plates are planar so as to correspond to the flat planar shape of the thermoelectric module. However, when the plates are formed into a flat shape, the stiffness of the plate is reduced with the result that the plates may be deformed under the pressure of the high temperature fluid and the low temperature fluid, and this deformation may cause a damage to the thermoelectric module by applying pressure thereto. Also, if the surfaces of the plates are planar, turbulent flow of the high temperature fluid and the low temperature fluid may not be created with the result that the high temperature fluid and the low temperature fluid may not be uniformly supplied to the surfaces of the plates, and the efficiency of heat exchange between the plates, and the high temperature fluid and the low temperature fluid may be impaired.

In view of such a problem of the prior art, a primary object of the present invention to shape such plates for a thermoelectric power generation device so as to conform to the thermoelectric module, and increase the stiffness of the plates.

### MEANS TO ACCOMPLISH THE TASK

To achieve such an object, a certain aspect of the present invention provides a thermoelectric power generation device (1), comprising a plurality of units (7) that are stacked upon one another, each unit including a thermoelectric module (5) containing at least one thermoelectric element (15A, 15B), and a first plate (2) and a second plate (3) interposing the thermoelectric module therebetween, wherein a spacer (32) is interposed between a surface (2A) of one of the first plates facing away from the corresponding thermoelectric module and a surface (3B) of the opposing second plate facing away from the corresponding thermoelectric module, the spacer contacting the first plate and the second plate and defining a fluid passage (51, 52) jointly with the first plate and the second plate, and wherein the fluid passages defined between the adjacent units are configured to receive supply of high temperature fluid and low temperature fluid in an alternating manner in a stacking direction of the units.

According to this aspect of the present invention, since the one first plate and the opposing second plate are supported by the spacer interposed between the first plate and the second plate, a high stiffness can be achieved, and deformation can be avoided. In addition, since the stiffness of the first and second plates is increased by the spacer, the first and second plates can be made of thin and planar members, further improving the heat exchange efficiency between the thermoelectric module, and the high temperature fluid and the low temperature fluid.

In this aspect of the present invention, each spacer may be attached to one of the corresponding first plate and second plate.

According to this aspect of the present invention, the stiffness of the plate to which each spacer is attached can be further improved.

In this aspect of the present invention, each spacer may be a metal plate (33) bent so as to form a plurality of protrusions and depressions (33A, 33B).

According to this aspect of the present invention, each spacer can be formed with a simple structure.

In this aspect of the present invention, each thermoelectric module may be bonded to one of the first plate and the second plate, and may be in contact with the other of the first plate and the second plate.

According to this aspect of the present invention, at the time of servicing the thermoelectric power generation device, the other of the first plate and the second plate and the thermoelectric module can be easily separated from each other so that breakage of the thermoelectric module is prevented.

In this aspect of the present invention, the thermoelectric module is bonded to one of the first plate and the second plate and contacts a metal film (25) attached to the other of the first plate and the second plate.

Thereby, the contact between the metal film and the thermoelectric module is enhanced by the deformation of the metal film so that the efficiency of heat transfer between the thermoelectric module and the associated plates can be improved.

In this aspect of the present invention, the metal film may be attached to the other of the first plate and the second plate via a thermally conductive grease (21).

Thereby, the thermally conductive grease further improves the contact between the metal film and the thermoelectric module. In addition, the contact between the metal film and the corresponding plate is improved.

In this aspect of the present invention, parts (2G, 3G) of the first plate and the second plate which face the thermoelectric module are formed as planar surfaces.

Thereby, the heat exchange between the plate like thermoelectric module, and the first and second plates is promoted owing to an increase in the contact area between the thermoelectric module, and the first and second plates. As a result, the temperature difference created between the two ends of the thermoelectric module is increased so that the power generation efficiency of the thermoelectric module improves.

Another aspect of the present invention provides a thermoelectric power generation method using the above defined thermoelectric power generation device, comprising the step of supplying the high temperature fluid of a comparatively high temperature and the low temperature fluid of a comparatively low temperature to the fluid passages defined in the spacers in an alternating manner in the stacking direction of the units.

According to this aspect of the present invention, a highly efficient thermoelectric power generation can be achieved.

### EFFECT OF THE INVENTION

According to these aspects of the present invention, in the thermoelectric power generation device, the plates can be conformed to the shape of the thermoelectric module, and the stiffness of the plates can be increased.

### BRIEF DESCRIPTION OF THE DRAWING(S)

Figure 1 is an exploded perspective view of a thermoelectric power generation device according to an embodiment of the present invention;
Figure 2 is an exploded perspective view of one of a plurality of units of the thermoelectric power generation device viewed from a side of a first plate;
Figure 3 is an exploded perspective view of one of a plurality of units of the thermoelectric power generation device viewed from a side of a second plate;
Figure 4 is a sectional view of a thermoelectric module;
Figure 5 is an enlarged perspective view of a first surface of the first plate; and
Figure 6 is a sectional view of the thermoelectric power generation device.

### DESCRIPTION OF THE PREFERRED EMBODIMENT(S)

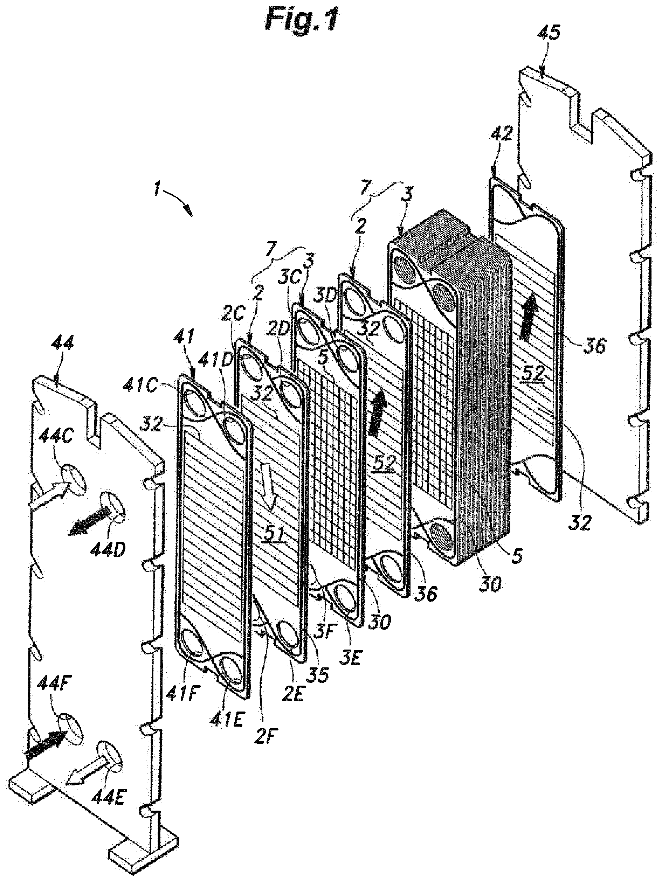

A preferred embodiment of the present invention is described in the following with reference to the appended drawings. As shown in Figure 1, the thermoelectric power generation device 1 has a plurality of plates 2 and 3 and thermoelectric modules 5 each interposed between predetermined plates 2 and 3. The plates 2 and 3 and the thermoelectric modules 5 are grouped into a plurality of identical minimum units 7 each consisting of the thermoelectric modules 5, and the first plate 2 and the second plate 3 interposing the thermoelectric modules 5 therebetween.

The first plate 2 and the second plate 3 belonging to each unit 7 are each made of a metallic plate member having a substantially rectangular identical shape. In the illustrated embodiment, the first plates 2 and the second plates 3 are provided with a shape of a rectangle elongated in the vertical direction. The first plates 2 and the second plates 3 are each provided with a front surface 2A, 3A and a rear surface 2B, 3B and are arranged such that the major planes thereof face in a fore and aft direction. In particular, the first plates 2 and the second plates 3 are stacked in the fore and aft direction so that the rear surface 2B of each first plate 2 faces the front surface 3A of the corresponding second plate 3 (belonging to the adjoining unit 7).

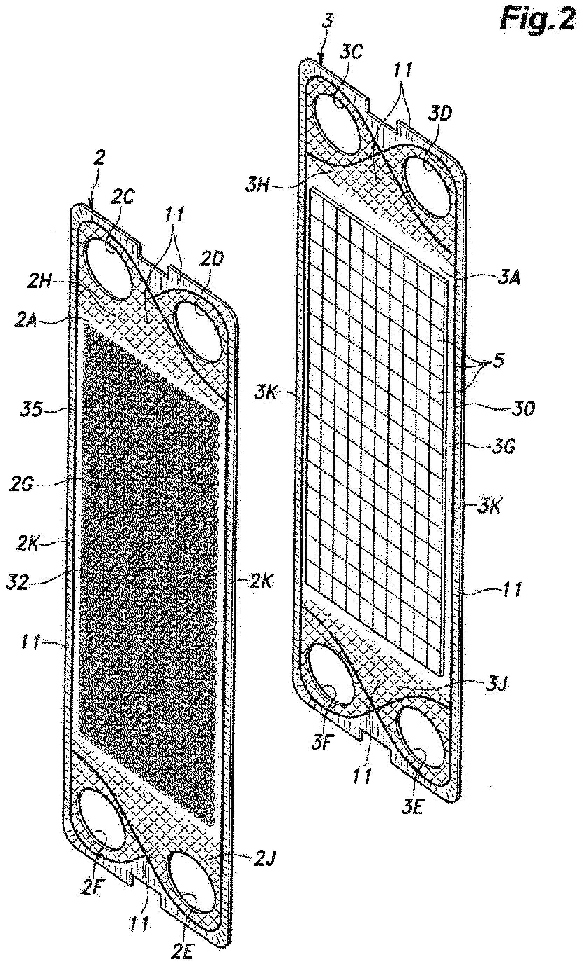

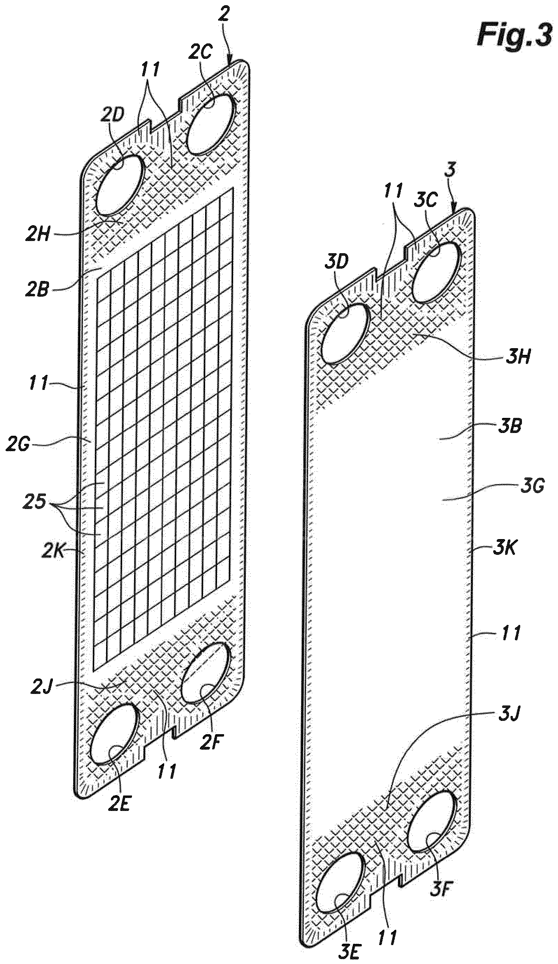

As shown in Figures 2 and 3, the first plates 2 and the second plates 3 are each provided with a first hole 2C, 3C, a second hole 2D, 3D, a third hole 2E, 3E, and a fourth hole 2F, 3F passed though the plate at four corners of the rectangular shape. The first holes 2C and 3C of the first and second plates 2 and 3 oppose each other. Similarly, the second holes 2D and 3D, the third holes 2E and 3E, and the fourth holes 2F and 3F of the first and second plates 2 and 3, respectively, oppose each other. When viewed by a person facing forward, the first holes 2C and 3C are located on the upper right corners, the second holes 2D and 3D are located on the upper left corners, the third holes 2E and 3E are located on the lower left corners, and the fourth holes 2F and 3F are located on the lower right corners of the plates 2 and 3, respectively. Each hole may be circular in shape, for example.

The rear surface 2B of a central part 2G of each first plate 2 and the front surface 3A of a central part 3G of the second plate 3 are each formed as a smooth flat surface. More specifically, the central parts 2G and 3G as used herein mean central parts with respect to the vertical direction of the respective plates 2 and 3, excluding the left and right side edge parts 2K and 3K of the plates 2 and 3. Upper end parts 2H and 3H including the peripheries of the first holes 2C and 3C and the second holes 2D and 3D of the plates 2 and 3, and lower end parts 2J and 3J including the peripheries of the third holes 2E and 3E and the fourth holes 2F and 3F, and the left and right side edge parts 2K, 3K extending vertically on either side of the central parts 2G, 3G are embossed in such a manner that a plurality of beads 11 (irregularities) are formed on the front and rear surfaces. These beads 11 have a function of increasing the bending stiffness of the first plates 2 and the second plates 3. In addition, as will be described later, flow separation and vibrations of the fluid flowing along the front surfaces of the first plates 2 and the rear surfaces of the second plates 3 are induced so that turbulence is promoted in the flow.

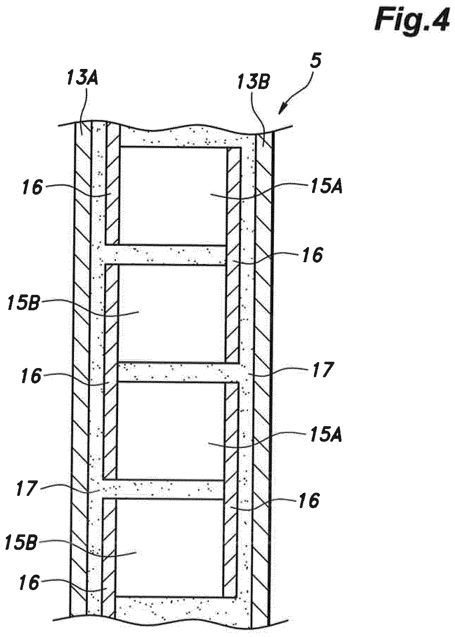

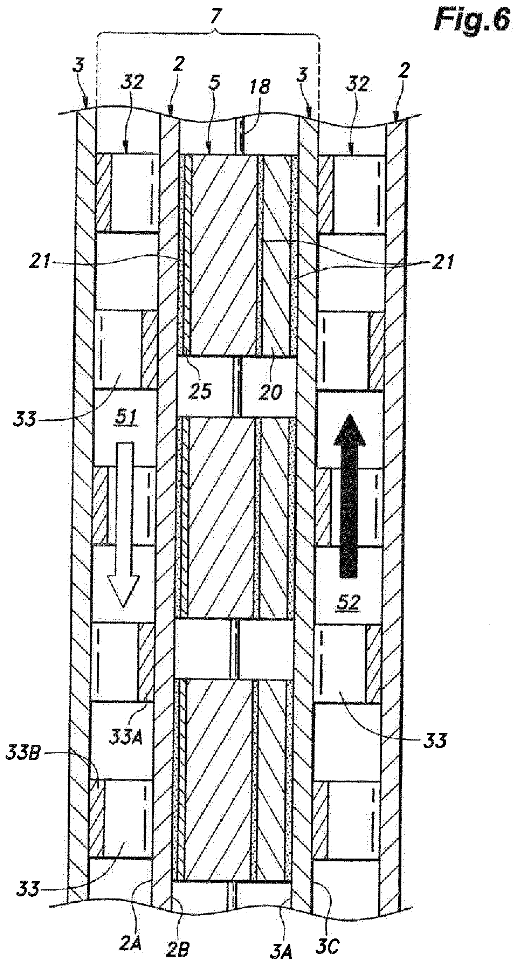

A plurality of thermoelectric modules 5 are arranged in the central part 3G of the front surface of each second plate 3. Each thermoelectric module 5 consists of a plurality of thermoelectric elements 15A and 15B arranged in a plane, and generates electric power owing to a temperature difference existing between two sided thereof. As shown in Figure 4, for example, each thermoelectric module 5 includes a pair of plates 13A and 13B, and the thermoelectric elements 15A and 15B are arranged between the two plates 13A and 13B. The thermoelectric elements 15A and 15B are configured to convert thermal energy into electric energy by the Seebeck effect, and include a plurality of p-type semiconductors 15A and a plurality of n-type semiconductors 15B. The thermoelectric elements 15A and 15B are arranged in a planar fashion along the respective plates 13A and 13B between the two plates 13A and 13B. The end portion of each thermoelectric element 15A positioned on the side of one of the plates 13A is connected to the end portion of the adjacent thermoelectric element 15B on the side of the one plate 13A via an electrode 16. Similarly, the end portion of each thermoelectric element 15A positioned on the side of the other plate 13B is connected to the end portion of the adjacent thermoelectric element 15B on the side of the other plate 13B via an electrode 16. An insulator 17 is interposed between the thermoelectric elements 15A and 15B and between each electrode 16 and the opposing plate 13A. Thus, the thermoelectric elements 15A and 15B form an electric circuit. The thermoelectric elements 15A and 15B may be connected in series, in parallel or in any other way. In the illustrated embodiment, the thermoelectric elements 15A and 15B contained in each thermoelectric module 5 are connected in series, and the electrodes forming the two ends of the electric circuit are connected to respective lead wires (See Figure 6).

The edges of the two plates 13A and 13B constituting each thermoelectric module 5 are connected to each other except for the parts from which the lead wires 18 are drawn out. Each thermoelectric module 5 is formed in a flat rectangular parallelepiped shape having a major plane defined by the plates 13A and 13B, or, in other words, in a plate shape. The thermoelectric modules 5 is positioned on the front surface 3A of the second plate 3 in such a manner that the major plane thereof is directed in the fore and aft direction. The front and rear surfaces of the thermoelectric modules 5 are formed as smooth flat surfaces.

As shown in Figure 6, a shim plate 20 is interposed between the central part 3G of the front surface 3A of each second plate 3 and the corresponding thermoelectric modules 5. The shim plate 20 is provided with a prescribed thickness which is selected in dependence on the distance between the rear surface 2B of the first plate 2 and the front surface 3A of the second plate 3 in such a manner that the front surface of the plates 13A of the thermoelectric modules 5 can contact the rear surface 2B of the first plate 2 or a member attached to the rear surface 2B. The shim plate 20 is made of metal having a high thermal conductivity such as copper or aluminum, and is provided with a smooth and flat front surface and rear surface. A thermally conductive grease 21 is interposed between the shim plate 20 and the central part 3G of the front surface 3A of the second plate 3 and between the shim plate 20 and the rear surface of the thermoelectric modules 5. The thermally conductive grease 21 may consist of a per se known thermally conductive grease in which particles of metal or metal oxide having high thermal conductivity such as copper, aluminum, magnesium oxide or the like are dispersed in silicone grease or the like. The thermally conductive grease 21 fills the gap between the central part 3G of the front surface 3A of the second plate 3 and the shim plate 20, and the gap between the shim plate 20 and the thermoelectric modules 5 so that the thermal conductivity between the second plate 3 and the thermoelectric modules 5 may be improved.

The shim plate 20 is held attached to the central part 3G of the front surface 3A of the second plate 3, and the thermoelectric modules 5 are held attached to the front surface of the shim plate 20, owing to the viscosity of the thermally conductive grease 21 in each case. The lead wires 18 of the thermoelectric modules 5 may be connected in series, in parallel or in other way as required.

As shown in Figures 3 and 6, the central part 2G of the rear surface 2B of each first plate 2 retains a metal film 25 with a thermally conductive grease 21. The metal film 25 is formed of copper, aluminum or the like. The metal film 25 may be divided into a plurality of pieces so as to correspond to the front surfaces of the individual thermoelectric modules 5, or may consist of a single piece as to correspond to the front surfaces (plates 13A) of the thermoelectric modules 5. The metal film 25 is preferably sized so as to come into contact with the whole area of the front surface of each individual thermoelectric module 5, and prevent a contact between the thermally conductive grease 21 and the thermoelectric modules 5.

As shown in Figures 1 and 2, a first gasket 30 is interposed between the rear surface 2B of the first plate 2 and the front surface 3A of the second plate 3. The first gasket 30 includes a frame portion that surrounds the central parts 2G and 3G of the first and second plates 2 and 3, a frame portion that surrounds the first holes 2C and 3C, a frame portion that surrounds the second holes 2D and 3D, a frame portion that surrounds the third holes 2E and 3E, and a frame portion that surrounds the fourth holes 2F and 3F. The parts of the rear surface 2B of the first plate 2 and the front surface 3A of the second plate 3 which are in contact with the first gasket 30 are provided with planar surfaces. Parts of the frame portion surrounding the central parts 2G and 3G that do not overlap with any of the remaining frame portions are formed with lead out portions through which the lead wires 18 are passed. The lead out portions may be formed by reducing the thickness of the corresponding parts of the first gasket 30.

When the first plate 2 and the second plate 3 are assembled to each other with the first gasket 30 interposed therebetween, the space defined between the rear surface 2B of the first plate 2 and the front surface 3A of the second plate 3 is divided into a space containing the central parts 2G and 3G, a space containing the first holes 2C and 3C, a space containing the second holes 2D and 3D, a space containing the third holes 2E and 3E, and a space containing the fourth holes 2F and 3F, and these spaces are individually sealed. In another embodiment, the space containing the central parts 2G and 3G is communicated with the outside. In the assembled state, the front surface of each thermoelectric module 5 is in surface contact with the metal film 25 provided on the rear surface 2B of the corresponding first plate 2.

As shown in Figure 2, a spacer 32 is provided in the central part 2G of the front surface 2A of each first plate 2. When the plurality of units 7 are stacked in the fore and aft direction, the spacer 32 abuts against the central part 2G of the front surface 2A of the first plate 2 and the central part 3G of the rear surface 3B of the second plate 3 at a plurality of locations so that a distance between the front surface 2A of the first plate and the rear surface 3B of the second plate 3 is maintained, and, at the same time, affords a stiffness to the central parts 2G and 3G of the first plate 2 and the second plate 3 by supporting the central parts 2G and 3G of the first plate 2 and the second plate 3.

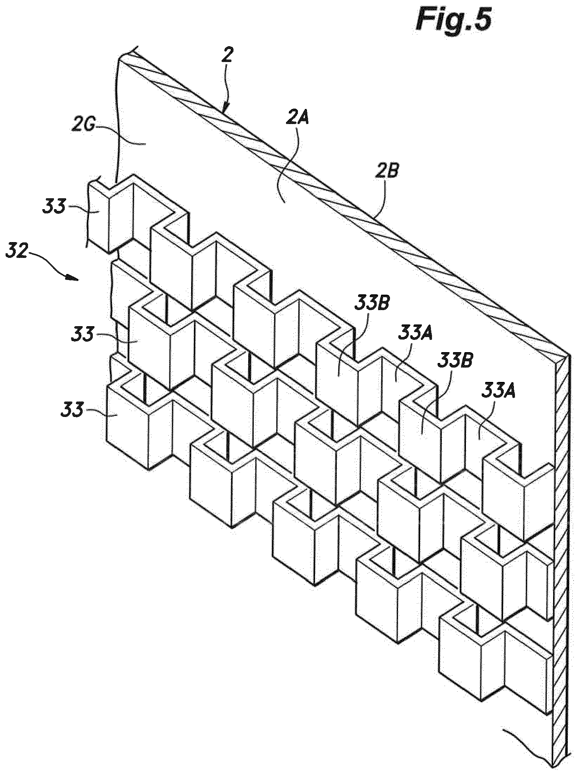

As shown in Figure 5, in the illustrated embodiment, the spacer 32 includes a plurality of metal strips 33 (metal plates) extending in the lateral direction and each bent in a wavy manner such that each metal strip 33 is provided with protrusions 33B projecting forward and recesses 33A recessed rearward at a regular interval and in an alternating manner. The metal strips 33 are vertically arranged in a mutually spaced apart relationship in such a manner that the protrusions 33B of each metal strip 33 is offset from the protrusions 33B of the adjoining metal strips 33 by one half of the width of each protrusion 33B. As a result, the passages (spaces) formed by the protrusions 33B and the recesses 33A are not aligned in the vertical direction (shifted laterally) with the result that the turbulence of the fluid flowing through the passages is further promoted. In another embodiment, the metal strips 33 are offset laterally from the adjoining metal strips 33 by the width of each protrusion 33B. The parts of the metal strips 33 corresponding to the bottoms of the recesses 33A are in surface contact with the front surface 2A of the first plate 2, and are welded to the front surface 2A of the first plate 2. The front end surfaces of the protrusions 33B are located on a common hypothetical plane which is in parallel with the front surface 2A of the first plate 2. Therefore, when the units 7 are stacked upon one another, the front end surfaces of the protrusions 33B are in surface contact with the central parts 3G of the rear surfaces 3B of the second plate 3.

As shown in Figure 1, a second gasket 35 or a third gasket 36 is interposed between the rear surface 3B of the second plate 3 and the front surface 2A of the first plate 2. The second gasket 35 includes a frame portion continuously surrounding the central parts 2G and 3G of the first and second plates 2 and 3, the first holes 2C and 3C, and the third holes 2E and 3E, a frame portion surrounding the holes 2D and 3D, and a frame portion surrounding the fourth holes 2F and 3F. The third gasket 36 includes a frame portion continuously surrounding the central parts 2G and 3G of the first and second plates 2 and 3, the fourth holes 2F and 3F, and the third holes 2E and 3E, a frame portion surrounding the holes 2C and 3C, and a frame portion surrounding the third holes 2E and 3E. The second gasket 35 and the third gasket 36 are alternately disposed between the rear surface 3B of the second plate 3 and the front surface 2A of the first plate 2 when the plurality of units 7 are stacked upon one another. In other words, the first plate 2, the first gasket 30, the second plate 3, the second gasket 35, the first plate 2, the first gasket 30, the second plate 3, and the third gasket 36 are stacked upon one another in this order in a repeated pattern.

In the assembled state in which the second gasket 35 is interposed between the first plate 2 and the second plate 3, the space between the rear surface 3B of the second plate 3 and the front surface 2A of the first plate 2 is divided into a space containing the central parts 2G and 3G, the first holes 2C and 3C, and the third holes 2E and3E, a space containing the second holes 2D and 3D, and a space containing the fourth holes 2F and 3F, and these divided spaces are individually sealed. In the assembled state, the tip end surfaces of the protrusions 33B of the spacer 32 are in surface contact with the central parts 3G of the rear surface 3B of the second plate 3.

A front end plate 41 is positioned on the front side of the units 7 stacked upon one another in the fore and aft direction, and a rear end plate 42 is positioned on the rear side of the units 7. The front end plate 41 has a configuration similar to that of the first plate 2. Specifically, the front end plate 41 is provided with a first to a fourth hole 41C to 41F corresponding to the first to fourth holes 2C to 2F, and a spacer 32 is positioned on the front surface of the front end plate 41. The rear end plate 42 has a configuration similar to that of the first plate 2 except for that the first to fourth holes 2C to 2F are absent in this case, and a spacer 32 is positioned on the front surface of the rear end plate 42. A front outer plate 44 is positioned on the front side of the front end plate 41, and a rear outer plate 45 is positioned on the rear side of the rear end plate 42.

The front outer plate 44 is provided with a high temperature fluid inlet hole 44C opposing the first hole 41C of the front end plate 41, a low temperature fluid outlet hole 44D opposing the second hole 41D, a high temperature fluid outlet hole 44E opposing the third hole 41E, and a low temperature fluid inlet hole 44F opposing the fourth hole 41F. The high temperature fluid inlet hole 44C, the low temperature fluid outlet hole 44D, the high temperature fluid outlet hole 44E, and the low temperature fluid inlet hole 44F penetrate the front outer plate 44 in the thickness direction. The high temperature fluid inlet hole 44C is connected to a high temperature fluid source, the high temperature fluid outlet hole 44E is connected to a high temperature fluid discharge drain, the low temperature fluid inlet hole 44F is connected to a low temperature fluid source, and the low temperature fluid outlet hole 44D is connected to a low temperature fluid discharge drain.

A first gasket 30 is interposed between the rear surface of the front outer plate 44 and the front surface of the front end plate 41. A second gasket 35 is interposed between the rear surface of the front end plate 41 and the front surface 2A of the first plate 2 of the unit 7 arranged at the frontmost end. A third gasket 36 is interposed between the rear surface 3B of the second plate 3 of the unit 7 arranged at the rearmost end and the front surface of the rear end plate 42.

The front outer plate 44 and the rear outer plate 45 are joined by a plurality of tie rods (not shown in the drawings) extending in the fore and aft direction. The front end plate 41, the plurality of units 7, the rear end plate 42, and the various gaskets 30, 35 and 36 are clamped between the front outer plate 44 and the rear outer plate 45 in the fore and aft direction.

The rear surface of the front outer plate 44, the first gasket 30, and the front surface of the front end plate 41 jointly define a passage connecting the high temperature fluid inlet hole 44C with the first hole 41C, a passage connecting the low temperature fluid outlet hole 44D with the second hole 41D, a passage connecting the high temperature fluid outlet hole 44E with the third hole 41E, and a passage connecting the low temperature fluid inlet hole 44F with the fourth hole 41F.

The rear surface 2B of the first plate 2, the first gasket 30, and the front surface 3A of the second plate 3 jointly define a passage connecting the first holes 2C and 3C of the first and second plates 2 and 3 to each other, a passage connecting the second holes 2D and 3D to each other, a passage connecting the third holes 2E and 3E to each other, and a passage connecting the fourth holes 2F and 3F to each other, while separating the central parts 2G and 3G where the thermoelectric modules 5 are disposed from these passages.

The rear surface 3B of the second plate 3 (or the rear surface of the front end plate 41), the second gasket 35, and the front surface 3A of the first plate 2 jointly define a high temperature fluid passage 51 that connects the first holes 2C and 3C (41C), the central parts 2G and 3G, and the third holes 2E and 3E (41E) of the respective plates 2 and 3 (41) to one another. The high temperature fluid passage 51 extends obliquely in a diagonal direction from the first holes 2C and 3C (41C) to the third holes 2E and 3E (41E) (Refer to white arrows in Figures 1 and 6) or from above to below. The high temperature fluid passage 51 is provided with a larger lateral width in the central parts 2G and 3G than in the upper end parts 2H and 3H and the lower end parts 2J and 3J.

The rear surface 3B of the second plate 3, the second gasket 36, and the front surface 3A of the first plate 2 (or the front surface of the rear end plate 42) jointly define a low temperature fluid passage 52 that connects the second holes 2D and 3D (41D), the central parts 2G and 3G, and the fourth holes 2F and 3F (41F) of the respective plates 2 and 3 (41) to one another. The low temperature fluid passage 52 extends obliquely in a diagonal direction from the fourth holes 2F and 3F (41F) to the second holes 2D and 3D (41D) (Refer to black arrows in Figures 1 and 6) or from below to above. The low temperature fluid passage 52 is provided with a larger lateral width in the central parts 2G and 3G than in the upper end parts 2H and 3H and the lower end parts 2J and 3J.

Owing to such arrangements, the high temperature fluid supplied to the high temperature fluid inlet hole 44C sequentially passes through the first holes 2C, 3C and 41C, the high temperature fluid passages 51, the third holes 2E, 3E and 41E, and is discharged from the high temperature fluid outlet hole 44E. Meanwhile, the low temperature fluid supplied to the low temperature fluid inlet hole 44F sequentially passes through the fourth holes 41F, 2F and 3F, the low temperature fluid passages 52, the second holes 3D, 2D and 41D, and is discharged from the low temperature fluid outlet hole 44D. As a result, the high temperature fluid and the low temperature fluid flow along the front surface 2A of the first plate 2 and the rear surface 3B of the second plate 3, respectively, as counterflows so that a temperature difference is created between the front surface 2A and the rear surface 3B of the two plates 2 and 3 interposing the thermoelectric modules 5 therebetween.

In the thermoelectric power generation device 1 of the embodiment configured as described above, since the central parts 2G and 3G of the first plate 2 and the second plate 3 facing the thermoelectric modules 5 are formed as planar surfaces, the contact area between the first plate 2 and the thermoelectric modules 5 intervened by the metal film 25, and the contact area between the second plate 3 and the thermoelectric modules 5 intervened by the shim plate 20 are maximized so that heat exchange between the thermoelectric modules 5, and the first plate 2 and the second plate 3 can be promoted. As a result, the temperature difference created between the front surface and the rear surface of the thermoelectric modules 5 increases, and the power generation efficiency of the thermoelectric modules 5 is improved. Since the first and second plates 2 and 3 are supported by the spacers 32 arranged between the first and second plates 2 and 3, the stiffness of the first and second plates 2 and 3 increases, and is prevented from deforming. In addition, since the stiffness of the first and second plates 2 and 3 is increased by the spacers 32, it is possible to reduce the thickness of the first and second plates 2 and 3, and this further improves the heat exchange efficiency between the thermoelectric modules 5, and the high temperature fluid and the low temperature fluid.

Since each spacer 32 is attached to the first plate 2, the stiffness of the first plate 2 is further improved. Further, since each spacer 32 is attached to the first plate 2, the thermoelectric power generation device 1 can be easily assembled.

Each spacer 32 crosses the high temperature fluid passage 51 and the low temperature fluid passage 52 so as to distribute the high temperature fluid passage 51 and the low temperature fluid passage 52 into a plurality of passages at discrete locations. Therefore, the turbulence of the flows of the high temperature fluid and the low temperature fluid can be enhanced. This also promotes homogenization of the high temperature fluid and the low temperature fluid flowing in the high temperature fluid passage 51 and the low temperature fluid passage 52. In addition, flow separation of the high temperature fluid and the low temperature fluid from the front surface 2A of the first plate 2 and the rear surface 3B of the second plate 3 is promoted by the spacer 32, and this also promotes the turbulent flow. As a result, heat exchange between the high temperature fluid and the low temperature fluid and the first and second plates 2 and 3 is promoted.

If both of the surfaces of the thermoelectric modules 5 are in contact with the first plate 2 and the second plate 3 with an adhesive such as thermally conductive grease 21 or the like, when the first plate 2 and the second plate 3 are removed, the thermoelectric modules 5 could be damaged. In the illustrated embodiment, only the rear surface of the thermoelectric modules 5 is brought into close contact with the shim plate 20 provided on the second plate 3 by the thermally conductive grease 21 while the front surface of the thermoelectric modules 5 is simply brought into contact with the rear surface 2B of the first plate 2, the thermoelectric modules 5 are protected from excessive loading, and prevented from breaking when the rear surface 2B of the first plate 2 and the front surface 3A of the second plate 3 disassembled at the time of maintenance or the like, so that breakage of the thermoelectric modules 5 is avoided.

The metal film 25 is adhered to the rear surface 2B of the first plate 2 by the thermally conductive grease 21. Therefore, the metal film 25 can be deformed together with the thermally conductive grease 21 so as to conform to the front surface of the thermoelectric modules 5 so that the contact between metal film 25 and the thermoelectric modules 5 is improved.

The present invention has been described in terms of a specific embodiment, but is not limited by this embodiment, and can be modified without departing from the spirt of the present invention. For example, in the above embodiment, the spacer 32 is attached to the front surface 2A of the first plate 2, but the spacer 32 may also be attached to the rear surface 3B of the second plate 3, instead of the front surface 2A of the first plate 2. Furthermore, the spacer 32 may also be attached to both the front surface 2A of the first plate 2 and the rear surface 3B of the second plate 3. It can also be arranged such that the first spacer 32 is attached to the front surface 2A of the first plate 2 while the second spacer 32 is attached to the rear surface 3B of the second plate 3, and the first spacer 32 and the second spacer 32 are in contact with each other. The spacer 32 may not be attached to either the first plate 2 or the second plate 3, and may be interposed between the front surface 2A of the first plate 2 and the rear surface 3B of the second plate 3.

Further, in the illustrated embodiment, the spacer 32 is formed of a plurality of metal strips 33 (metal plates) independent from each other. However, the metal strips 33 may be connected to each other by a connecting member or the like extending vertically. Further, a single plate having irregularities formed by embossing or the like may be connected to the first plate 2.

In an alternate embodiment, the spacer 32 is interposed between the first plate 2 and the second plate 3 without being welded or bonded to either the first plate 2 or the second plate 3. The spacer 32 partitions the space between the first plate 2 and the second plate 3 into a plurality of continuous passages (spaces). The spacer 32 may be formed from a single member or a plurality of members. Each member constituting the spacer 32 may consist of a plate-like member which is provided with a plurality of protrusions and depressions formed by embossing or the like, or a plurality of through holes. The spacer 32 may be positioned relative to the first plate 2 and the second plate 3 by being engaged by protrusions formed on the first plate 2 and/or the second plate 3. Furthermore, the spacer 32 may be provided with engagement portions configured to be engaged by the edges of at least some of the first holes 2C and 3C, the second holes 2D and 3D, the third holes 2E and 3E, and the fourth holes 2F and 3F of the first plate 2 and the second plate 3 so that the spacer 32 may be positioned relative to the first plate 2 and the second plate 3 by the engagement portions thereof engaging at least some of the first to fourth holes 2C-2F, 3C-3F, of the first plate 2 of the second plate 3.

Furthermore, the spacer 32 may be integrally formed with the second gasket 35 or the third gasket 36 interposed between the first plate 2 and the second plate 3. In such a case, the spacer 32 may be formed of the same material as the gaskets 35, 36, or may be made of a different material from the gaskets 35, 36 and connected thereto.

The shim plate 20 may be omitted depending on the thickness of the thermoelectric modules 5 and the distance between the rear surface 2B of the first plate 2 and the front surface 3A of the second plate 3. In such a case, the rear surface of the thermoelectric modules 5 may be retained on the front surface 3A of the second plate 3 by using the thermally conductive grease 21.

In the above embodiment, as shown in Figure 6, a plurality of thermoelectric modules 5 are connected by the lead wires 18. Alternatively, a plurality of thermoelectric modules 5 may be disposed on a printed board on which a circuit is formed, and thermoelectric modules 5 may be connected to the lead wires 18 via the printed circuit. The printed circuit board may be directly held on the shim plate 20 or the second plate 3 by using the thermally conductive grease 21. It is preferable that the printed circuit board consists of a flexible printed circuit board having a small thickness.

In the above embodiment, the flow directions of the high temperature fluid passage 51 and the low temperature fluid passage 52 are inclined with respect to the vertical direction. However, in an alternate embodiment, the flow directions of the high temperature fluid passage 51 and the low temperature fluid passage 52 extend vertically and in parallel to each other. In such a case, the high temperature fluid inlet hole 44C is disposed at the upper left corner part of the front outer plate 44 and connected to the second holes 2D and 3D, the high temperature fluid outlet hole 44E is disposed at the lower left corner part of the front outer plate 44, the low temperature fluid inlet hole 44F is disposed at the lower right corner part of the front outer plate 44 and connected to the fourth holes 2F and 3F, and the low temperature fluid outlet hole 44D is disposed at the upper right corner part of the front outer plate 44 and connected to the first holes 2C and 3C. In addition, the second gasket 35 includes a frame portion continuously surrounding the central parts 2G and 3G, the first holes 2C and 3C, and the fourth holes 2F and 3F of the first and second plates 2 and 3, a frame portion surrounding the second holes 2D and 3D, and a frame portion surrounding the third holes 2E and 3E. The third gasket 36 may include a frame portion continuously surrounding the central parts 2G and 3G of the first and second plates 2 and 3, the second holes 2D and 3D, and the third holes 2E and 3E, a frame portion surrounding the holes 2C and 3C, and a frame portion surrounding the fourth holes 2F and 3F.

The configuration of the thermoelectric modules 5 shown in Figure 4 is an example, and various other per se known configurations can also be applied.

In the above embodiment, the first plate 2, the second plate 3, and the like are formed with a substantially rectangular outer shape, but the shape may be freely selected such as a circle.

**GLOSSARY OF TERMS**

| | | | |
|---|---|---|---|
| 1 | thermoelectric power generation device | | |
| 2 | first plate | 2A | front surface |
| 2B | rear surface | 2G | central part |
| 3 | second plate | 3A | front surface |
| 3B | rear surface | 3G | central part |
| 3H | upper end part | 3J | lower end part |
| 5 | thermoelectric module | 7 | unit |
| 11 | beads | 15A, 15B | thermoelectric element |
| 20 | shim plate | 21 | thermally conductive grease |
| 25 | metal film | 30 | first gasket |
| 32 | spacer | 33 | metal plate |
| 33A | recess | 33B | protrusion |
| 35 | second gasket | 36 | third gasket |
| 51 | high temperature fluid passage | | |
| 52 | low temperature fluid passage | | |

## Claims

1. A thermoelectric power generation device, comprising
a plurality of units that are stacked upon one another, each unit including a thermoelectric module containing at least one thermoelectric element, and a first plate and a second plate interposing the thermoelectric module therebetween,
wherein a spacer is interposed between a surface of one of the first plates facing away from the corresponding thermoelectric module and a surface of the opposing second plate facing away from the corresponding thermoelectric module, the spacer contacting the first plate and the second plate and defining a fluid passage jointly with the first plate and the second plate, and
wherein the fluid passages defined between the adjacent units are configured to receive supply of high temperature fluid and low temperature fluid in an alternating manner in a stacking direction of the units.

2. The thermoelectric power generation device according to claim 1, wherein each spacer is interposed between the first plate and the second plate.

3. The thermoelectric power generation device according to claim 1 or 2, wherein each spacer is attached to one of the corresponding first plate and second plate.

4. The thermoelectric power generation device according to claim 2 or 3, wherein each spacer is a metal plate bent so as to form a plurality of protrusions and depressions.

5. The thermoelectric power generation device according to any one of claims 1 to 4, wherein each thermoelectric module is bonded to one of the first plate and the second plate, and is in contact with the other of the first plate and the second plate.

6. The thermoelectric power generation device according to any one of claims 1 to 4, wherein the thermoelectric module is bonded to one of the first plate and the second plate and contacts a metal film attached to the other of the first plate and the second plate.

7. The thermoelectric power generation device according to claim 6, wherein the metal film is attached to the other of the first plate and the second plate via a thermally conductive grease.

8. The thermoelectric power generation device according to any one of claims 1 to 7, wherein parts of the first plate and the second plate which face the thermoelectric module are formed as planar surfaces.

9. A thermoelectric power generation method using the thermoelectric power generation device according to any one of claims 1 to 8, comprising the step of supplying the high temperature fluid of a comparatively high temperature and the low temperature fluid of a comparatively low temperature to the fluid passages defined in the spacers in an alternating manner in the stacking direction of the units.
